(19) Europäisches Patentamt

European Patent Office

Office européen des brevets

(11) **EP 1 550 745 A1**

(12) **EUROPEAN PATENT APPLICATION**

(43) Date of publication:
**06.07.2005 Bulletin 2005/27**

(51) Int Cl.⁷: **C30B 11/00**, C30B 29/12

(21) Application number: **03293332.7**

(22) Date of filing: **24.12.2003**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicant: **CORNING INCORPORATED
Corning, NY 14831 (US)**

(72) Inventors:
• **Thomas Jean Glasson
F-77210 Avon (FR)**
• **Nicolas Leblond
Corning, NY 14830 (US)**
• **Alexandre Michel Mayolet
F-28700 Aneau (FR)**

(74) Representative: **Poole, Michael John
Corning Limited
Patents & Licensing Department
Quantum House,
Maylands Avenue
Hemel Hempstead, Herts. HP2 7DE (GB)**

(54) **Metal fluoride crystals suitable for UV applications prepared from particles having a small surface area**

(57) The invention is directed to a method of preparing metal fluoride crystals that are suitable for making optical elements that can be used in below 200 nm lithographic equipment and processes. In accordance with the invention, metal fluoride particles, substantially all of which have a size of 1 mm or greater, are treated with an oxygen scavenger material just prior to being melted and used to grow a metal fluoride single crystal. In one embodiment of the invention a metal fluoride raw material is treated with an oxygen scavenger to remove oxygen containing impurities, liquefied and cooled to form a premelt material. The premelt material is then broken into particles having a range of sizes and separated by sieving or other separation methods known in the art into at least a group of particles substantially all of which have a size of 1 mm or larger and a group of particles having a size of less than 1 mm. The 1 mm and larger material is used to grow metal fluoride single crystals having improved transmission properties in the rage 120-220nm.

The less than 1 mm material can be recycled. Particles of 1 mm or greater prepared by other methods known in the art can also be used in practicing the invention.

Figure 3

**EP 1 550 745 A1**

Printed by Jouve, 75001 PARIS (FR)

**Description**

Field of the Invention

The invention is directed to optical fluoride crystals suitable for making optical elements used in the transmission of wavelengths below 200 nm, and in particular to a method of making such crystals by the use of sized particles of a selected optical fluoride premelt material.

Background of the Invention

The burden of the demands for improved performance of computers and other electronic devices falls on the lithographic processes used to fabricate integrated circuit chips. Lithography involves irradiating a mask and focusing the pattern of this mask through an optical microlithography system onto a wafer coated with a photoresist. The pattern on the mask is thereby transferred onto the wafer. Decreasing the line-widths of the features on a given wafer enables the writing on a wafer of more elements per unit area and consequently brings about advances in performance. The enhanced resolution required to achieve finer line-widths is enabled by decreasing the wavelength of the illumination source. As a result of the desire to achieve finer line widths, the energies used in lithographic patterning are moving deeper into the UV region. Consequently, optical components capable of reliable performance at these increasingly shorter optical microlithography wavelengths are required.

Few materials are known that have a high transmittance at wavelengths below 200 nm, for example, at 193 nm and 157 nm, and also do not deteriorate under exposure to intense laser radiation. Fluoride crystals such as those of magnesium fluoride, calcium fluoride and barium fluoride are potential materials with high transmittance at wavelengths < 200 nm. Calcium fluoride crystals are particularly preferred for making optical elements for use at below 200 nm wavelengths. However, the commercial use and adoption of below 200 nm wavelengths has been hindered by the transmission nature of such deep ultraviolet wavelengths through optical materials and by the lack of economically manufacturable, high quality blanks of optically transmissive materials suitable for below 200 nm microlithography optical elements. Many factors go into making metal fluoride crystals and elements suitable for use in below 200 nm lithography. One of these is the purity of the metal fluoride starting material used to make a metal fluoride single crystal and subsequently an optical element.

The transmission of a metal fluoride crystal is greatly dependent on the purity of the starting material. Commercially available raw material powders are sufficiently pure in terms of cationic impurities, but these materials are not sufficiently pure in terms of the anionic impurities they contain. In order to remove these anionic impurities, mainly oxygen containing species, a purification step is carried out using a gaseous or a solid oxygen scavenger, or both, such as known in the art. Examples of such scavengers are solid lead fluoride ($PbF_2$), zinc fluoride ($ZnF_2$) or gaseous carbon tetrafluoride ($CF_4$). There are numerous patents and technical articles whose authors discuss the detrimental effects of water and oxygen, and the necessity for adding an oxygen scavenger to remove these contaminants. For examples, see J. M. Ko *et al*., "Czochralski growth of UV grade $CaF_2$ single crystals using $ZnF_2$ additive as scavenger", *J. Crystal Growth* **222** (2001) 243-248 [with references to the use of $PbF_2$ and $CF_4$ as scavengers]; R. C. Pastor, "Crystal growth of metal fluorides for $CO_2$ laser operation. I. The necessity of the RAP approach", *J. Crystal Growth* **200** (1999) 510-514, and "Crystal growth of metal fluorides for $CO_2$ laser operation. II. Optimization of the reactive atmosphere process (RAP) choice.", *J. Crystal Growth* **203** (1999) 421-424; and J.T. Mouchovski et al., "Growth of ultra-violet grade $CaF_2$ crystals and their application for excimer laser optics.", *J. Crystal Growth* **162** (1996) 79-82. See also United States patent numbers 4, 379,733 and 6, 238,479, and European Patent Application Publication No. EP 0 995 820 A1.

In a process for removing oxygen-containing anionic impurities from a metal fluoride raw material, a metal fluoride powder is melted in the presence of an oxygen scavenger. The scavenger reacts with the oxygen containing species and converts it to a fluoride material. The resulting melt or liquid is then quickly cooled down in order to obtain a purified, high density metal fluoride material that will be used in crystal growth furnaces to fabricate the desired metal fluoride crystal. This specific purification-melting process of the raw material powder is generally called a "premelt" step or "cullet" production.

For below 200 nm lithographic optical material the quality of the premelt material may be quantified by determining the transmission characteristics of the premelt material in the wavelength range of 120-220 nm. In the absence of specific absorptions in VUV range at 130 nm, 150 nm and 193 nm , the premelt material is characterized as being an oxygen-free or substantially oxygen free material and hence suitable for making metal fluoride single crystals. Once the premelt's suitability for use in growing crystals has been determined, the premelt material is broken into pieces or ground into fine particles and loaded into crucibles that are placed in a crystal growth furnace. However, if the oxygen-free premelt material has been loaded into the crucible without the addition of an oxygen scavenger, or if the crystal growth is carried out in the absence of a gaseous oxygen scavenger, the crystal produced in the growth furnace will exhibit the characteristic oxygen absorption bands in the 120-220 nm range. The presence of these bands indicates that the oxygen-free premelt material has been re-contaminated by the formation of oxygen containing substances during handling or during the crystal growth process. The sources of contamination can be oxygen containing substances (for example, $H_2O$, $O_2$, $CO_2$ and other oxygen containing species) adsorbed on the surface of the premelt particles while they are being prepared for the crystal growth process or they can come from oxygen containing substances released from the materials used to make either the furnace or the components used in the crystal growth process. For example, the oxygen containing substances can be released from the crucibles, heating elements, and insulating parts of the furnace among others. In any event, when the furnace is heated in the absence of an oxygen scavenger, metal fluoride premelt material fluoride reacts with these oxygen containing substances and this in turn gives rise to a low transmittance crystal. For example, if water vapor is released from the insulation, the vapor can react with the metal fluoride to form a hydroxy metal fluoride. For example, $CaF_2 + H_2O \rightarrow Ca(OH)F + HF \uparrow$ or $CaO + 2HF \uparrow$

While the use of an oxygen scavenger during the crystal growth process can alleviate the oxygen contamination problem, such use can give rise to additional problems. For example, one must estimate the amount of contaminants present in the material and use sufficient scavenger to remove all of it. This is frequently difficult to determine. As a result, excess oxygen scavenger is used in the crystal growing process. While the use of excess scavenger does not present problems when the scavenger is gaseous, when a solid scavenger such as $PbF_2$ is used, the excess of scavenger could result in lead contamination of the grown crystal. If insufficient scavenger is used, then residual oxygen containing substances may be present in the grown crystal and these substances will absorb radiation in the 120-220 nm region, and consequently interfere with the transmission properties of the crystal and optical element made from it. Transmission of 96%/cm or greater at 157 nm and 99%/cm or greater at 193 nm of incident radiation is required for elements used in below 200 nm lithography.

Therefore, in view of the foregoing problems it is desirous to be able to identify metal fluoride materials that have characteristics that minimize the adsorption or presence of oxygen containing materials and to find a method of producing such materials.

Summary of the Invention

The invention is directed to a method for making metal fluoride single crystals suitable for use in below 200 nm lithographic equipment and processes. In one aspect the invention is directed to a method comprising:

    loading a metal fluoride material in which substantially all the particles have a size of 1 mm or greater into a crystal growth crucible and evacuating the furnace to a pressure in the range of $10^{-6}$ mBar;
    heating the particles while maintaining vacuum to a temperature in the range of 400-600 °C over a selected time to dry the materials and interior of the furnace;
    heating the particles while maintaining vacuum to a temperature in the range of 100-250 °C below the melting point of the metal fluoride in the presence of an oxygen scavenger and holding the temperature for a time in the range of 4-48 hours;
    melting the particles while maintaining vacuum and
    cooling the melt (suitable time and temperature regimens are known in the art) so as to produce a metal fluoride single crystal suitable for use in below 200 nm lithographic equipment and processes.

Use in optical equipment means making laser windows, lenses and other optical elements from the metal fluoride single crystal.

In one embodiment the oxygen scavenger is a solid oxygen scavenger added to the metal fluoride materials when it is placed in the crystal growth crucible.

In another embodiment a gaseous oxygen scavenger is used in addition to the solid oxygen scavenger and the gaseous oxygen scavenger is admitted into the furnace after the drying step and while the particles are being heated to a temperature in the range of 50-250 °C below the melting point of the metal fluoride, and the temperature is held at 50-250 °C below the metal fluoride's melting point for a period in the range of 4-48 hours. When using a gaseous oxygen scavenger the pressure within the furnace is increased from $10^{-6}$ mBar (vacuum state) to approximately 1000 mBar during the scavenging (or fluorinating) step. Once this step has been completed the pressure within the furnace is reduced to $10^{-6}$ mBar (vacuum conditions) and the process proceeds to the melting, crystal growing and cooling steps as described above. Alternatively, an inert gas for example, helium, argon or nitrogen) can be admitted and the melting, crystal growing and cooling steps carried out at atmospheric pressure.

In yet another embodiment the oxygen scavenging is conducted using only a gaseous oxygen scavenger as described in the paragraph above, including increasing the pressure within the furnace to approximately 1000 mBar. The steps after oxygen scavenging (the melting, crystal growing and cooling steps) remain the same, including reducing the pressure within the furnace to $10^{-6}$ mBar. When only a gaseous oxygen scavenger is used, the time scavenging (fluorinating) step time may be increased to a range of 4-96 hours to maximize the removal of oxygen containing species.

The method of the invention can further comprise making a premelt material that is ground and sieved, or otherwise separated into particles substantially all of which have a size of 1 mm or greater (for example, using cyclone separation), and using such particles in the growth crucible to make a metal fluoride single crystal suitable for use in below 200 nm lithographic equipment and processes. The method comprises:

heating and melting a metal fluoride raw material in a furnace in the presence of an oxygen scavenger material and cooling the melted material to form a solid premelt metal fluoride material;
converting the premelt material into particles having range of sizes;
separating the particles into at least a group of particles in which substantially all the particles have a size of 1 mm or larger and a group of particles having a size less than 1 mm;
placing the particles having a size greater than 1 mm and a oxygen scavenger into a crucible and heating the particles under vacuum to a temperature in the range of 400-600 °C over a selected time in the range of 4-48 hours to dry the materials and the interior of the furnace;
heating the particles in the presence of an oxygen scavenger while maintaining vacuum to a temperature in the range of 50-250 °C below the melting point of the metal fluoride,
melting the particles while maintaining vacuum, and
cooling the melt (suitable time and temperature regimens are known in the art) to ambient (room) temperature while maintaining vacuum to produce a metal fluoride single crystal suitable for use in below 200 nm lithographic equipment and processes.

A gas, preferably a dry gas, may be admitted into the furnace at any point after the metal fluoride crystal has been formed. Examples of such gases include air, nitrogen, argon and other inert gases.

In one embodiment the oxygen scavenger in the crystal growth steps is a solid oxygen scavenger added to the sieved, or other separated, metal fluoride materials having a size of 1mm or greater when it is placed in the crystal growth crucible.

In another embodiment a gaseous oxygen scavenger is used in the crystal growth steps in addition to the solid oxygen scavenger and the gaseous oxygen scavenger is admitted into the furnace after the drying step and while the particles are being heated to a temperature in the range of 50-250 °C below the melting point of the metal fluoride, and the temperature is held at 50-250 °C below the metal fluoride's melting point for a period in the range of 4-48 hours. When using a gaseous oxygen scavenger the pressure within the furnace is increasing from $10^{-6}$ mBar (vacuum state) to approximately 1000 mBar during the scavenging (or fluorinating) step. Once this step has been completed the pressure within the furnace is reduced to $10^{-6}$ mBar (vacuum conditions) and the process proceeds to the melting, crystal growing and cooling steps as described above. Alternatively, an inert gas (for example, helium, argon or nitrogen) can be admitted and the melting, crystal growing and cooling steps carried out at atmospheric pressure.

In yet another embodiment the solid scavenger is omitted and the entire oxygen scavenging during the crystal growth steps is conducted using a gaseous oxygen scavenger as described in the paragraph above, including increasing the pressure within the furnace to approximately 1000 mBar. The steps after oxygen scavenging (the melting, crystal growing and cooling steps) remain the same, including reducing the pressure within the furnace to $10^{-6}$ mBar. When only a gaseous oxygen scavenger is used, the time scavenging (fluorinating) step time may be increased to a range of 4-96 hours to maximize the removal of oxygen containing species.

In practicing the invention the metal fluoride particles are used, and substantially all of the particles have a size of 1 mm or greater are used. The metal fluoride material is treated with an oxygen scavenger to remove oxygenated impurities, liquefied and cooled to form a metal fluoride single crystal having improved properties for below200 nm lithographic processes. The particles of 1 mm or greater size can be prepared by any method known in the art; for example, as described herein or as described in U.S. Patent No. 6,451,106 B1.

In another aspect of the invention the particles are separated to have a size in the range of 1-10 mm and the 1-10 mm particles used to grow metal fluoride single crystals suitable for use as optical elements in below 200 nm lithographic equipment and processes. In a preferred embodiment the particles are separated into a size in the range of 1-7 mm and the 1-7 mm particles are used to grow an optical fluoride crystal.

The method is used to make single crystals of calcium fluoride, barium fluoride, magnesium fluoride and strontium fluoride, and can also be used to make single crystals containing mixtures of the foregoing metals. In addition, the method is also used to make crystals in which any of the crystals of the previous sentence also contains lanthanide series metal fluorides, lithium fluoride, potassium fluoride and sodium fluoride, either alone or in combination.

The invention is also directed to a metal fluoride single crystal suitable for making <200 nm lithography elements, said crystal being made by any of the methods described herein and in the claims.

Brief Description of the Drawings

Figure 1 is a SEM photograph showing the sieved particles in the size range 1-0.1 mm, the particles having an average size of approximately 0.2 mm.
Figure 2 is a SEM photograph showing the sieved particles of <0.1 mm size, the particles having an average size of about 0.01 mm.
Figure 3 illustrates the measured transmission for crystals prepared in Runs 1, 2 and 3.

Detailed Description of the Invention

The invention will now be described in detail with reference to a few preferred embodiments and the accompanying figures. In the following description numerous details are set forth in order to provide a thorough understanding of the invention. However, it will be apparent to one skilled in the art who reads this specification that the invention may be practiced without some of these specific details. In addition, well-known features and/or process steps have not been described in detail in order to not unnecessarily obscure the invention.

As used herein, the term "metal fluoride" means a fluoride of general formula $MF_2$, where M is calcium, barium, magnesium or strontium, and includes mixtures of the foregoing metals. Also as used herein, the terms "metal fluoride crystal" and "metal fluoride single crystals" are synonymous and should be understood to also include optical blanks and optical elements made from such crystals, for example, lenses, laser chamber windows, prisms and other optical elements.

Below 200 nm lithographic systems such as those operating at 193 nm and 157 nm require the use of lenses and other optical elements made from metal fluorides of general formula $MF_2$, where M is calcium, barium, strontium or magnesium, or mixtures thereof. Calcium fluoride ($CaF_2$) is a particularly preferred material for optical elements in below 200 nm lithographic systems. While calcium fluoride is used in the detailed description that follows to exemplify the invention, the invention is not restricted to calcium fluoride, but also includes barium fluoride, magnesium fluoride and strontium fluoride, and mixtures of such metal fluorides.

Generally, metal fluoride particles, substantially all of which have a size of the 1 mm or greater, are used to prepare a single crystal in accordance with the invention. These particles can be made by any method known in the art; for example, as in U.S. Patent No. 6,451,106 that describes the preparation of metal fluoride beads. The 1 mm or greater particles can also be prepared from an ingot of metal fluoride material as described below.

In order for a metal fluoride crystal, or element made therefrom, to be used in below 200 nm lithographic systems, and specifically 193 and 157 nm, the crystal transmission must be higher than 96%/cm or greater at 157 nm and 99%/cm or greater at 193 nm. As stated above, the transmission of the crystal is greatly dependent of the purity of the starting material. While raw material powders that are sufficiently pure in terms of cationic impurities are commercially available, they are not sufficiently pure in terms of their anionic impurities. In order to remove these anionic impurities, mainly oxygen related species; a purification step is carried out that uses a solid or gaseous oxygen scavenger to remove the oxygenated species. Examples of such scavengers include lead fluoride ($PbF_2$), stannous fluoride ($SnF_2$), zinc fluoride ($ZnF_2$), xenon difluoride ($XeF_2$), fluorinated and/or chlorofluoro hydrocarbons such as carbon tetrafluoride ($CF_4$), tetrafluoroethylene ($C_2F_4$) and hexafluoroethane ($C_2F_6$), and other oxygen scavengers known in the art. The raw powder is heated in the presence of the oxygen scavenger for a time and at temperatures known in the art to remove the oxygenated impurity. (See U.S. Patent Application Publications 2002/0160177 and 2003/0089304 whose teaching are incorporated herein by reference.) Subsequently, the purified raw material is melted *in situ* and the resulting metal or liquid quickly cooled down to obtain a purified high density premelt that can be used as the starting material in crystal growth furnaces to fabricate the desired metal fluoride single crystal. This specific purification-melting process of the raw material powder is generally called a "premelt" step or "cullet" production.

In accordance with the invention, the premelt material or mass is then ground or otherwise converted into particles and, instead of being directly loaded into a crystal growth furnace, the ground material is sieved, or otherwise separated, to remove particles having a particle size less than, for example, 1mm. The grinding can be done by any method known in the art. For example, the premelt mass can be hammered into pieces and/or particles, or the premelt mass can first be hammered into pieces and the size of the pieces further reduced by passage through one or more sets of rollers. Typically, metal hammers and rollers are used in this process. However, in order to avoid metal contamination of the premelt materials, the hammers and rollers can be coated with a suitable material. For example, the hammer or rollers can be coated with a polymeric material, preferably a partially or fully fluorinated polymeric material. If any of the fluorinated material becomes admixed with the processed premelt, it can serve as an oxygen scavenger during the subsequent crystal growth process.

Once the particles have been reduced in size they are sieved, or otherwise separated, to separate particles of different sizes. For example, in accordance with the invention it is desirable to use particles substantially all of which have a size greater than 1 mm. Accordingly, the ground premelt material is sieved using a sieve that will retain particles greater than 1mm and allow particles less than 1mm to pass through. Alternatively, a combination of sieves can be used to separate and collect particles in having a range of sizes; for example, particles in the range of 1-10 mm. In this instance a first sieve is used that will retain particles greater than 10 mm and allow particles less than 10 mm to pass through, and a second sieve is used that will retain particles greater than 1mm and allow particles less than 1 mm to pass through. If one wants further separation according to particle size, one can include other sieves to further separate the particles in to different ranges; for example, greater than 10 mm, 5-10 mm, 1-5 mm and less than 1 mm. The ground particles can also be separated by other method known in the art, for example cyclone separations. If a cyclone separator is used to separate the particles, it is preferred that the separation be carried out using a dried gas. In addition, it is preferred that the surfaces of the cyclone be pre-dried prior to the separation. This can be done by passing a hot dried gas through the cyclone prior to its being used for the particle separation. A hot gas including an oxygen scavenging gas can also be used to dry the cyclone.

In practicing the invention it is advantageous to use a sieved material, or material prepared by other methods such as U.S. Patent No. 6,451,106 patent, containing a range of particle sizes in order to pack the growth crucible as densely as possible. For example, instead of using a sieved material having particle sized in the range of 1-10 mm, one can use a sieved material having particle sizes in the range of 1-7 mm, preferably in the range 1-5 mm, because one can pack the growth crucible with a greater weight of material and hence utilize the volume of the crucible more efficiently by reducing the interstitial void volume between the particles. For a crucible of given diameter and volume one is thus able to grow a thicker crystal. However, restricting particles to the size range 1-7 mm and/or 1-5 mm is not an absolute requirement, and larger particles can be used. In the extreme limit one would not grind the premelt material and use it directly. However, one must take into account the difference in the coefficient of thermal expansion between the crucible (graphite or other material) and the $CaF_2$ premelt material to avoid fracturing the crucible during processing.

The sieved particles are loaded into a crucible and the crucible is placed in a crystal growth furnace where the particles are melted and used to grow a metal fluoride single crystal by methods known in the art; for example, the Stockbarger, Bridgman-Stockbarger and Czochralski methods, and the methods described in U.S. Patent numbers 6,630,117, 6,395,657, and 6,333,922 B1. An oxygen scavenger, solid or gaseous, or a combination of both, is used in conjunction with the sieved premelt particles. A solid oxygen scavenger is typically mixed with the particles before they are placed in the crucible. If the sieved premelt particles are used without adding an oxygen scavenger (either as a solid material mixed with the particles, or a gaseous material added during the process, or both) the resulting single crystals will have a transmission curve having the characteristic oxygen absorption bands. This is a result of the premelt being re-contaminated by oxygen containing substances during the growth process. As has already been mentioned, the sources of contamination can be oxygenated substances adsorbed on the surface of metal fluoride premelt particles during grinding and other handling, or coming from materials within the furnace, for example, the crucibles, heating elements and insulating materials. When the furnace and crucible containing the premelt materials is heated in the absence of an oxygen scavenger, calcium fluoride or other metal fluoride reacts with the oxygen containing substances and gives rise to a low transmittance crystal product.

The total quantity of oxygen containing substances trapped in the furnace is dependent of the properties of the materials used in making the furnace and equipment used therein; for example, the carbon materials used for the crucible and the furnace insulation. In addition, the total quantity is dependent on the amount of oxygen containing substances adsorbed on the ground premelt, and this amount is dependent on the premelt particles' total surface area. The reactivity of the premelt with gases produced by the furnace is also greatly dependent on its total surface area ("TSA"). The concentration of oxygen scavenger that is added to the premelt when it is charged to the crucible or otherwise added to the furnace during the growth process will vary with the TSA of the initial ground premelt. This complicates the overall process. Generally, the concentration of the oxygen scavenger is higher than necessary and longer holding times for the fluorination step of the growth process are used to overcome any re-contamination of the premelt material that may have occurred. However, this increases the manufacturing time and can result in contamination of the grown crystal by the oxygen scavenger itself, neither of which are desirable and both of which are costly.

The "fine" particles in a ground premelt (for example, particles less than 1 mm in size) have a high TSA. These fine particles contribute significantly to oxygen contamination of the $CaF_2$ product because their large total surface area is capable of adsorbing a significant amount of a contaminant such as water vapor that can subsequently react with the metal fluoride surface to produce species such as Ca(OH)F or CaO on the surface and lead to incorporate oxygen ions into the fluoride crystalline structure. In order to maximize the transmission at 193 nm and 157 nm, the present invention teaches that the metal fluoride premelt particles used to grow a metal fluoride single crystal for optical lithography use should have a particle size that is 1 mm or larger. That is, "fines" of less than 1 mm in size should be removed from the ground premelt material before it is used to grow a single metal fluoride crystal. The advantage of using larger premelt particles for crystal growth is that the total particle surface area is decreased, resulting in less water (and other oxygen containing species like $O_2$, $CO_2$, ...) being adsorbed during handling. When this is done metal fluoride crystals having a higher transmission are produced.

Assuming that the ground premelt $CaF_2$ particles will have a cubic or spherical shape, with no porosity and no roughness, the TSA for a given weight of particles can be calculated using Equation 1:

$$TSA = 6/da \qquad\qquad \text{Equation 1}$$

where: d = the theoretical density of the metal fluoride. For $CaF_2$, d=3.18 $g/cm^3$;

a = the length of a side for a cubic shaped particle or
the diameter of a spherical shape, both in centimeters (cm); and TSA is in $cm^2/g$.

The theoretical total surface area for different calcium fluoride premelt particle sizes is reported in Table 1. In reality, one must consider that the particles formed during grinding the premelt are not perfect cubes or spheres and that their surfaces develop roughness. Consequently, the experimental TSA, which could be measured using physisorption (with $N_2$ or Kr adsorbate, the latter being preferred), is a little higher than the theoretical estimate given by Equation 1. Nevertheless, Equation 1 gives a correct order of magnitude of the total surface area.

Table 1

| Theoretical Total Surface Area ($m^2/g$) for different $CaF_2$ premelt particles size | |
|---|---|
| a (mm) | TSA ($m^2/g$) |
| 100 | $1.9 \times 10^{-5}$ |
| 10 | ca. $1.9 \times 10^{-4}$ |
| 2.5 | 0.0007 |
| 1 | 0.0019 |
| 0.5 | 0.0038 |
| 0.2 | 0.0094 |
| 0.1 | 0.019 |
| 0.05 | 0.038 |
| 0.01 | 0.19 |
| 0.001 | 1.9 |
| 0.0001 | 18.9 |

As shown in Table 1, particles of 1 mm size have a TSA of approximately 0.0019 $m^2/g$ or less.

In order to exemplify the invention, a premelt material was ground and sieved in order to separate particles according to pre-selected size ranges. Table 2 shows the particle size ranges that were collected by sieving and the distribution in weight % of particles within each size range

Table 2:

| particle size distribution (wt %) of the premelt after grinding and sifting | | | |
|---|---|---|---|
| Premelt particle size | >1 mm | 1-0.1 mm | <0.1 mm |
| Weight % | 82 | 16 | 2 |

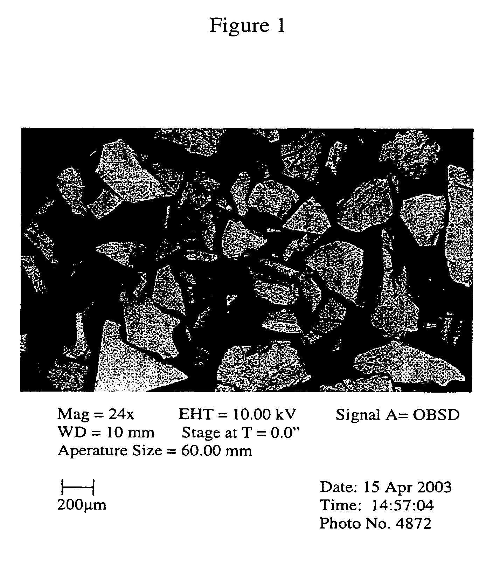

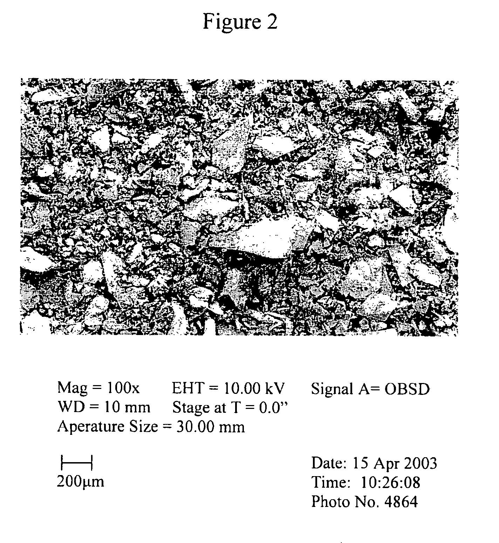

Figures 1 and 2 illustrate premelt size distribution of the sieved fractions 1-0.1 mm and < 0.1mm, respectively. The photographs show that:

(1) the average size for the sieved fraction 1-0.1 mm is approximately 0.2 mm, and
(2) the average size for the sieved fraction < 0.1 mm is approximately 0.01 mm.

Particles with a selected size have then been used to grow crystals. Experimental conditions are the same for each preparation (run). Specifically, the total quantity of $CF_4$, the oxygen scavenger, is the same for each run as are the time and temperature conditions under which the crystals were grown. The difference in results from run-to-run lies in the size distribution of the premelt particles that were used to make the crystals. The size distributions of the particles used in each run are as follows:

Run 1: 100% of the premelt loaded is characterized by particles size higher than 2.5 mm.
Run 2: 100% of the premelt loaded have particles size between 1 mm and 100 $\mu$m.
Run 3: 35 wt.% of the premelt loaded have particles size lower than 100 microns and 65 wt.% of the premelt loaded have particles size between 1 mm and 100 $\mu$m.

Using Figures 1 and 2 and Equation 1, it is possible to estimate the order of magnitude of the TSA of the fluoride premelt particles present in the crucible for each of Runs 1, 2 and 3 (see Table 3).

Table 3:

| Total Surface Area introduced in the crucible | | | |
|---|---|---|---|
| | Run 1 | Run 2 | Run 3 |
| Total Surface Area (m$^2$/g) | > 0.0007 | 0.0094 | 0.073 |

The crucibles containing the premelt particles are placed in a crystal growth furnace and heated in accordance with a crystal growth procedure as described below. During the heating of the furnace, the oxygenated species physisorbed (water, oxygen, carbon dioxide) and chemisorbed (chemical groups containing O atoms) on the surface of the $CaF_2$ particles will desorb and react with CaF2. It is known that oxygen incorporation in fluorides occurs preferentially by a mechanism of hydrolysis rather than oxidation. Very low partial pressure of water gas is sufficient to catalyse the diffusion of oxygen into fluorides. The quantity of oxygenated molecules desorbed in the furnace atmosphere increases when the TSA of the $CaF_2$ powder introduced in the crucible increases (proportionality relationship). It is possible to experimentally quantify these desorption differences using either (1) Temperature Programmed Desorption coupled to a Mass Spectrometer or (2) Infra-Red analysis.

The crystals grown in Runs 1-3 were made in a two heating zone furnace using the Bridgman-Stockbarger technique. The grown crystal dimensions have a 95 mm diameter and a height of 55 mm.

A graphite crucible containing a sieved premelt material was placed in a furnace and the furnace was heated while maintaining a vacuum ($10^{-6}$ mBar) to a temperature of approximately 1200 °C, which is below the melting point of calcium fluoride (mp = 1418 °C, Handbook of Physics & Chemistry 76th Ed., CRC Publishing, 1995-97). During the heating period the temperature was raised held at plateaus of 300 °C and 500 °C over a five hour period while vacuum was maintained. This was done in order to remove water adsorbed on graphite crucible, any carbon or graphite furnace elements, other elements present in the furnace and the calcium fluoride particles (the drying step). After the drying step the temperature was increased to 1200 °C at a rate of 100 °C/hour, still under vacuum. Once 1200 °C was reached, a gas mixture of argon, or other inert gas, and $CF_4$ was introduced into the furnace (the fluorination step). The $CF_4$ gas reacts with any oxides of calcium that may be present due to hydrolysis of $CaF_2$; for example, CaO, $Ca(OH)_2$ or Ca(OH)F. During the foregoing steps the pressure in the furnace is slowing increasing to approximately 1000 mBar. With the introduction of the scavenger containing gas, the fluorination or conversion of the oxides of calcium was carried out under dynamic conditions in which the $CF_4$ containing gas, 1 vol.% in an inert gas, was flowed through the furnace at atmospheric pressure. (For the preparation of crystals described herein, the $CF_4$ and argon were sourced from separate gas cylinders and were flowed into the furnace at a rate of 300 sccm Ar and 3 sccm $CF_4$). The fluorination step was carried out for 5 hours at a temperature of 1200 °C. Once the fluorination is completed, the furnace atmosphere is switch back to $10^{-6}$ mBar and the temperature of the $CaF_2$ material is raised to its melting point and a crystal is grown according to the according to methods known in the art. The growth of crystals of selected orientation, for example, a <111>, <110> or <100> crystal can be done by using a crucible having a reservoir in its bottom into which a <111> seed crystal is placed.

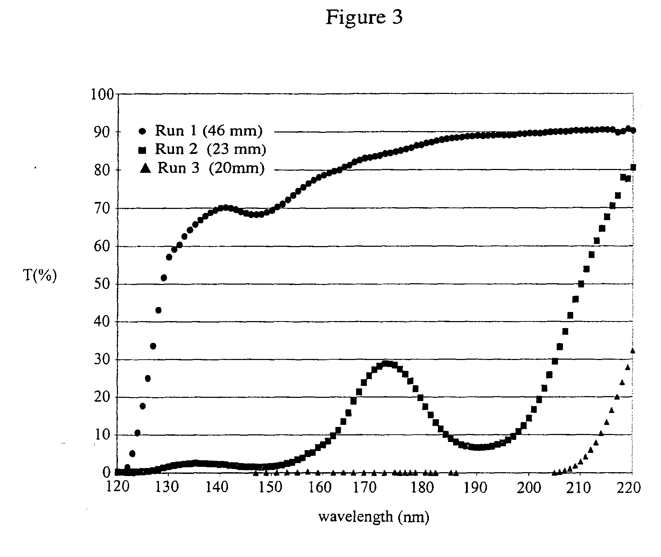

The VUV measured transmission of the crystals produced in Runs 1-3 is shown in Figure 3. The optical path length of the measured crystal is Run 1 is 48 mm, in Run 2 it is 23 mm, and in Run 3 it is 20 mm. The spectra shown in Figure 3 indicate that optical transmission is strongly decreasing from Run 1 to Run 3, with Run 2 being an intermediate case. The crystal used in Run 2, which has a 23 mm optical path length, is totally opaque in VUV range. The spectra of the Run 2 crystal shows the characteristic oxygen-fluorine vacancy center absorption bands at 130 nm, 150 nm and 193 nm. The crystal of Run 3 is even more contaminated by oxygen than is the crystal of Run 2. Only the crystal of Run 1 gives satisfactory performance. The crystal of Run 1 has an optimized transmission in VUV range over 48 mm thickness that demonstrates that the oxygen content of the Run 1 crystal is much lower that that of the crystals of Runs 2 and 3.

The transmission data in Figure 3 clearly indicates that the crystal prepared in Run 1 is the best crystal, having a relatively flat and increasing transmittance from 120-220 nm. In addition, the thickness (optical path) of the Run 1 crystal, 48 mm, is more than twice that of the crystals of Runs 2 and 3. The transmittance data for the crystal of Run 1 demonstrates that using a sieved material having a size greater than 1 mm produces superior crystals having improved transmittance. Using the data in Figure 3 one can calculate a 157 nm internal transmission of 96.75 %/cm.

To improve the transmission, residual small particles have to be eliminated and the $CF_4$ total quantity increased (total quantity = %$CF_4$ x time). This means an increase in $CF_4$ concentration or/and holding time at 1200°C. The advantage to use low TSA premelt is the minimization of the oxygen content introduced in the crucible. The probability of obtaining a high UV transmittance crystal is thereby improved. This is demonstrated for the utilization of $CF_4$, and it should be the same for the utilization of solid fluorinating agents such $PbF_2$, $ZnF_2$ and others known in the art. The crystals of Runs 2 and 3 would not be acceptable for deep UV applications, nor could the crystals of these runs be ground and polished into acceptable crystals or made into acceptable optical elements. They will not resist the 193 nm or 157 nm laser flux, and they present induced absorptions in the UV-Visible range of electromagnetic radiation.

For a constant concentration of oxygen scavenger in the process, the contamination by oxygen is increasing with the TSA of the loaded ground premelt. This contamination in oxygen is related to oxygenated species adsorbed on the surface of the premelt and then desorbing in the furnace during heating. When the TSA of the ground premelt increases, the quantity of adsorbed oxygen containing substances can be higher and the reactivity of the premelt material with the adsorbed substances increases. That is, the efficiency of the contaminant formation process is higher with a high TSA premelt powder, giving rise to a strongly contaminated material. As shown in Figure 3, the concentration of contaminant in Run 3 is higher than in Run 1. The concentration of oxygen scavenger (or fluorinating agent) would have to be increased in Run 3 in order to eliminate the contamination. Fine particles contribute to increase the raw material TSA, and consequently the water concentration introduced with the metal fluoride raw material added to the crucible. In order to have a controllable growth process, fine particles are excluded and only raw material having particle size higher than 1mm is loaded into the crucible for crystal growth.

The foregoing examples of specific compositions, processes, articles and/or apparatus employed in the practice of the present invention are, of course, intended to be illustrative rather than limiting, and it will be apparent that numerous variations and modifications of these specific embodiments may be practiced within the scope of the appended claims.

*Any discussion of the background to the invention herein is included to explain the context of the invention. Where any document or information is referred to as "known ", it is admitted only that it was known to at least one member of the public somewhere prior to the date of this application. Unless the content of the reference otherwise clearly indicates, no admission is made that such knowledge was available to the public or to experts in the art to which the invention relates in any particular country (whether a member-state of the PCT or not), nor that it was known or disclosed before the invention was made or prior to any claimed date. Further, no admission is made that any document or information forms part of the common general knowledge of the art either on a world-wide basis or in any country and it is not believed that any of it does so.*

**Claims**

1. A method for making a metal fluoride single crystal suitable for use in below 200 nm lithographic equipment and process, said method comprising:

   loading a particulate metal fluoride material into a crystal growth crucible, wherein substantially all the particles have a size of 1mm or greater, and evacuating the furnace to a pressure of approximately $10^{-6}$ mBar;
   heating the particles under vacuum to a temperature in the range of 400-600 °C over a selected time to dry the materials and the interior of the furnace;
   heating the particles while maintaining vacuum to a temperature in the range of 100-250 °C below the melting point of the metal fluoride in the presence of an oxygen scavenger and holding the temperature for a time in the range of 4-48 hours;
   melting the particles while maintaining vacuum and
   cooling the melt so as to produce a metal fluoride single crystal suitable for use in below 200 nm lithographic equipment and processes.

2. The method according to claim 1, wherein substantially all the particles have a size in the range of 1-10 mm.

3. The method according to claim 1, wherein substantially all the particles have a size in the range of 1-7 mm.

4. The method according to any one of claims 1-3, further comprising the steps of preparing metal fluoride particles having a size of 1mm or larger, said steps comprising:

heating and melting a metal fluoride raw material in a furnace in the presence of an oxygen scavenger material and cooling the melted material to form a solid premelt metal fluoride material;
converting the premelt material into particles having range of sizes;
separating the particles into at least a group of particles substantially all of which have a size of 1 mm or larger and a group of particles having a size less than 1 mm; and
loading said particles of size 1 mm or greater into a crucible as claimed in claims 1-3.

5. The method according to any one of claims 1-4, wherein the oxygen scavenger is a solid oxygen scavenger mixed with the particles prior to their being placed in the growth crucible, and the selected time is in the range of 4-48 hours.

6. The method according to any one of claims 1-4, wherein the oxygen scavenger is a gaseous oxygen scavenger that is admitted into the furnace after the drying step and while the particles are being heated to a temperature in the range of 50-250 °C below the melting point of the metal fluoride; and

the temperature is held at 50-250 °C below the metal fluoride's melting point for a selected time in the range of 4-96 hours with the gaseous scavenger being present; and

the pressure within the furnace is increasing from a vacuum pressure of approximately $10^{-6}$ mBar to approximately 1000 mBar during the scavenging step; and

once the scavenging step is completed has been completed the pressure within the furnace is reduced to $10^{-6}$ mBar r (vacuum conditions) and the process proceeds to the melting, crystal growing and cooling steps as described.

7. The method according to any one of claims 1-4, wherein a solid oxygen scavenger mixed with the particles prior to their being placed in the growth crucible; and

a gaseous oxygen scavenger that is admitted into the furnace after the drying step and while the particles are being heated to a temperature in the range of 50-250 °C below the melting point of the metal fluoride; and

the temperature is held at 50-250 °C below the metal fluoride's melting point for a selected time in the range of 4-48 hours with the gaseous scavenger being present; and

the pressure within the furnace is increasing from a vacuum pressure in the range of $10^{-6}$ mBar to approximately 1000 mBar during the scavenging step; and

once the scavenging step is completed has been completed the pressure within the furnace is reduced to 6-10 mBar and the process proceeds to the melting, crystal growing and cooling steps as described.

8. The method according to claims 6 or 7, wherein when the scavenging step is complete an inert gas is admitted and the melting, crystal growing and cooling steps are carried out at atmospheric pressure.

9. The method according to any one of claims 1-4, wherein the crucible comprises a crucible having a reservoir in its bottom for the placement of an oriented metal fluoride seed crystal and an oriented metal fluoride seed crystal is placed in the bottom of said crucible.

10. The method according to any one of claims 1-9, wherein heating and melting a metal fluoride raw material to form a solid premelt comprises heating and melting a metal fluoride of general formula $MF_2$, where M is calcium, barium, magnesium and strontium, and mixtures thereof.

Figure 1

Mag = 24x       EHT = 10.00 kV       Signal A= OBSD
WD = 10 mm      Stage at T = 0.0"
Aperature Size = 60.00 mm

⊢————⊣                               Date: 15 Apr 2003
200µm                                Time:  14:57:04
                                     Photo No. 4872

## Figure 2

Mag = 100x    EHT = 10.00 kV    Signal A= OBSD
WD = 10 mm    Stage at T = 0.0"
Aperature Size = 30.00 mm

⊢——⊣
200µm

Date: 15 Apr 2003
Time:  10:26:08
Photo No. 4864

## Figure 3

**European Patent Office**

## EUROPEAN SEARCH REPORT

Application Number

EP 03 29 3332

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 451 106 B1 (MAYOLET ALEXANDRE M ET AL) 17 September 2002 (2002-09-17) * column 2-3 * --- | 1-10 | C30B11/00 C30B29/12 |
| A | US 6 238 479 B1 (OBA TOMORU) 29 May 2001 (2001-05-29) * the whole document * --- | 1-10 | |
| A | PATENT ABSTRACTS OF JAPAN vol. 2000, no. 26, 1 July 2002 (2002-07-01) & JP 2001 240497 A (KOBE STEEL LTD), 4 September 2001 (2001-09-04) * abstract * ----- | 1-10 | |

TECHNICAL FIELDS SEARCHED (Int.Cl.7)

C30B

The present search report has been drawn up for all claims

| Place of search | Date of completion of the search | Examiner |
|---|---|---|
| MUNICH | 4 June 2004 | Brisson, O |

EPO FORM 1503 03.82 (P04C01)

**EP 1 550 745 A1**

## ANNEX TO THE EUROPEAN SEARCH REPORT
## ON EUROPEAN PATENT APPLICATION NO.

EP 03 29 3332

04-06-2004

| Patent document cited in search report | | | Publication date | Patent family member(s) | | Publication date |
|---|---|---|---|---|---|---|
| US 6451106 | B1 | | 17-09-2002 | FR | 2799194 A1 | 06-04-2001 |
| | | | | AU | 7617400 A | 10-05-2001 |
| | | | | CN | 1420819 T | 28-05-2003 |
| | | | | EP | 1226028 A1 | 31-07-2002 |
| | | | | JP | 2003511327 T | 25-03-2003 |
| | | | | WO | 0125001 A1 | 12-04-2001 |
| | | | | US | 2003000456 A1 | 02-01-2003 |
| US 6238479 | B1 | | 29-05-2001 | JP | 11228292 A | 24-08-1999 |
| | | | | EP | 0995820 A1 | 26-04-2000 |
| | | | | JP | 2000191322 A | 11-07-2000 |
| | | | | US | 6488769 B1 | 03-12-2002 |
| JP 2001240497 | A | | 04-09-2001 | NONE | | |

EPO FORM P0459